Europäisches Patentamt

European Patent Office

Office européen des brevets

(19)

(11) Publication number: 0 355 841

A2

# (12) EUROPEAN PATENT APPLICATION

(21) Application number: 89115709.1

(22) Date of filing: 25.08.89

(51) Int. Cl.⁴: G06F 15/60

(30) Priority: 26.08.88 JP 213269/88

(43) Date of publication of application:
28.02.90 Bulletin 90/09

(84) Designated Contracting States:
DE FR GB IT NL

(71) Applicant: NEC CORPORATION
33-1, Shiba 5-chome
Minato-ku Tokyo(JP)

(72) Inventor: Suzuki, Shinichi c/o NEC
Corporation
33-1, Shiba 5-chome
Minato-ku Tokyo(JP)

(74) Representative: Vossius & Partner
Siebertstrasse 4 P.O. Box 86 07 67
D-8000 München 86(DE)

(54) Automatic routing method using prioritized routability indices.

(57) For successively establishing a point-to-point electrical connections between pin terminals, a path is successively searched for each pin terminal pair and a connection is established if the search path is not intercepted by obstructing paths. If the attempt fails, a plurality of routability indices are generated to evaluate candidate paths. The routability index is a measure of the likelihood of finding a new path from each pin terminal through the obstructing paths, and is specifically represented by the number of paths that can be passed through a removed segment of a given obstructing path. Priorities of different levels are derived from the routability indices and are assigned to the obstructing paths which are to be ripped up to create a path for a new connection. One of the prioritized obstructing paths is selected according to the priorities and is removed to permit a new path to be searched for to determine if it is intercepted by further obstructing paths. If the new path is found, a connection is established; if not, the removed obstructing path is replaced and a prioritized obstructing path of lower priority is removed and a further new path is searched.

**Fig. 2**

## Automatic Routing Method Using Prioritized Routability Indices

The present invention relates generally to wire routing systems for determining paths for point-to-point electrical connections in integrated circuits and printed circuit boards, and more particularly to the improvement of connectivity of the routing systems with a minimum of human interventions using a rip-up technique.

A major problem with all known routers, such as maze router, channel and line probe router, is their tendency not to complete all necessary point-to-point connections even though some might exist as discussed in "Performance of interconnection rip-up and reroute strategies", William A. Dees, Jr. and Robert J. Smith, II, 18th Design Automation Conference, 1981 IEEE, Paper 18.3, pages 382-390. An attempt was made to remove or rip-up previously wired connections to increase the availability of resources as discussed in "Automated rip-up and reroute techniques", William A. Dees, Jr. and Patrick G. Karger, 19th Design Automation Conference, 1982 IEEE, Paper 27.4, pages 432-439. However, it is still difficult to achieve 100% connectivity. The inability of a router to achieve 100% connectivity necessitates human intervention to connect the remaining wiring and hence the turnaround time becomes substantial.

It is therefore an object of the present invention to provide an automatic routing method which minimizes human intervention with improved connectivity.

According to the present invention, a path is successively searched for each of a plurality of pin terminal pairs and a point-to-point connection is established if the searched path is not intercepted by obstructing paths. If the searched path is intercepted by the obstructing paths, a plurality of routability indices are generated to evaluate candidate paths. The routability index is a measure of the likelihood of finding a new path from each of the pin terminals through the obstructing paths. Specifically, the routability index is represented by the number of paths that can be passed through a removed segment of a given obstructing path. Priorities of different levels are derived from the routability indices and are assigned to the obstructing paths which are to be ripped up to create a path for a new connection. One of the prioritized obstructing paths is selected according to the priorities and is removed to permit a new path to be searched for to determine if it is intercepted by further obstructing paths. If the new path is found, a connection is established; if not, the removed obstructing path is replaced, and the process is repeated so that a prioritized obstructing path of lower priority is removed and a further new path is searched.

The present invention will be described in further detail with reference to the accompanying drawings, in which:

Fig. 1 is a schematic block diagram of a routing system of the present invention;

Fig. 2 is a flowchart describing the programmed operation of the controller of Fig. 1; and

Fig. 3 is a schematic illustration for describing window sizes between pin terminals.

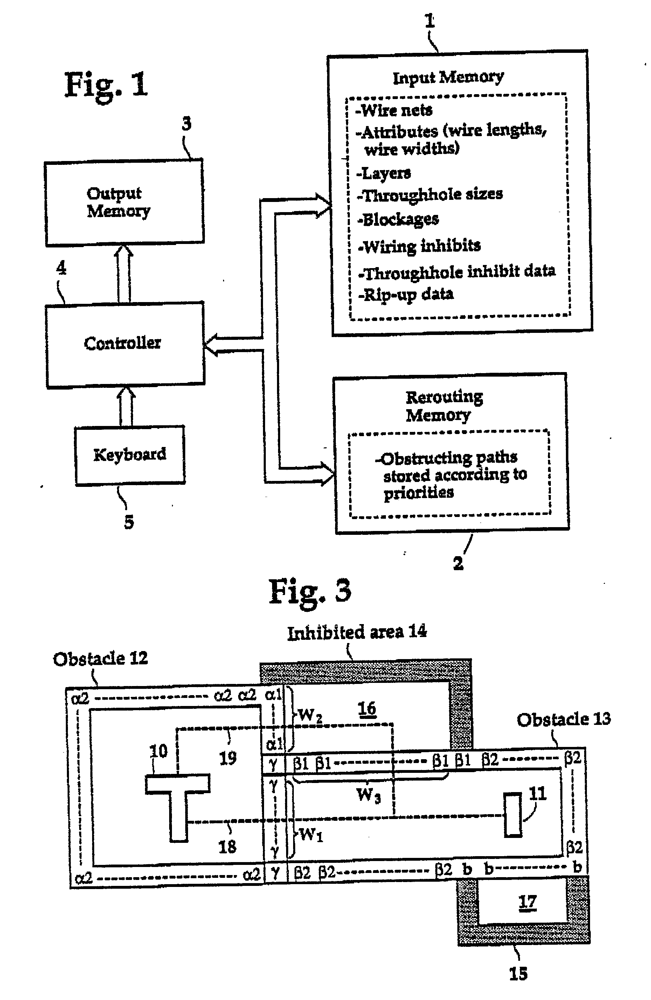

Referring now to Fig. 1, there is shown a routing system of the present invention. The system includes an input memory 1 for storing various items of wiring data entered by a controller 4 from a keyboard 5, a rerouting memory 2 and an output memory 3. The data stored in the input memory 1 include wire nets each being represented by a set of points to be electrically connected, attributes such as wire lengths and wire widths, layer information, throughhole sizes, blockages, wiring and throughhole inhibit data, and wire rip-up data. On the other hand, the rerouting memory 2 stores obstructing path data which can be recalled according to assigned priorities in a manner as will be described. The path information of each wiring path is stored into the output memory 3 as a connection is established between pin terminals on a cell map. The cell map is partitioned into an array of rectangular cells, the locations of which are identified by a system of X-Y coordinates. All pin terminals, wired paths, blockages, throughholes, unoccupied areas are broken down into groups or strings of cells and arranged on the cell map.

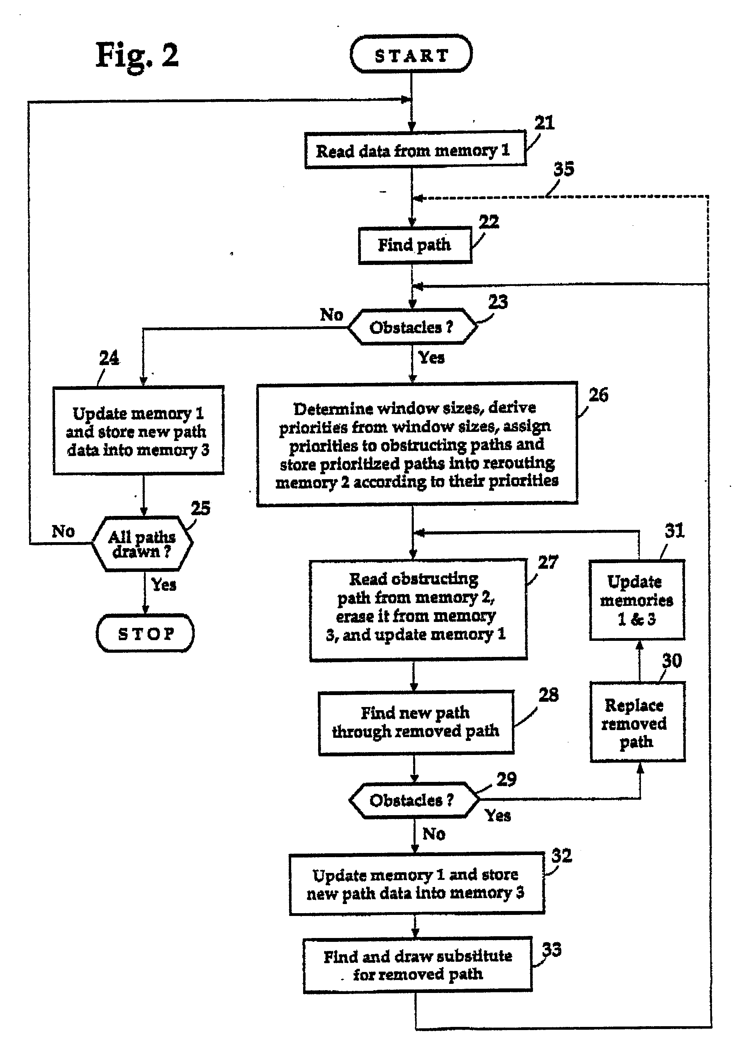

Controller 1 is programmed to sequentially execute the steps as described in the flowchart of Fig. 2. Initially, the controller 1 reads data from the memory 1 (block 21) and finds a path for a selected wire net. Decision block 23 is then executed to check to see if the path is intercepted by obstructing drawn paths. If the answer is negative, control goes to block 24 to establish a connection by updating memory 1 by altering the wire net information and storing wiring inhibit and throughhole inhibit data, and by storing data concerning a new path into the output memory 3. Control proceeds to decision block 25 to check to see if paths are drawn for all the nets. If they are, control goes to the end of the program, and if not, returns to block 21 to continue the process.

If the attempted path is intercepted by obstructing paths, the answer is affirmative in block 23 and control exits to operations block 26 to determine a plurality of routability indices, or "window sizes", and priorities of different levels. The window size is a yardstick by which alternative routes are determined and is represented by the number of possible paths, either associated with a given source pin terminal (starting point) or a destination pin terminal (ending point), which can be passed through a removable segment, or "window", of the obstacle. More specifically, the window size evaluates the possibility of changing the route of a path between a given pair of unconnected pin terminals when one of several obstructing paths is cleared and is calculated for each connected obstructing path.

As shown in Fig. 3, if pin terminals 10 and 11 are isolated from the outside by rectangules 12 and 13, respectively, which are formed by previously wired paths and pin terminals, these rectangules constitute obstacles to a path to be wired between the terminals 10 and 11. It will be noted that there are several windows of different sizes in each obstacle.

The windows in the obstacle 10 are composed of a short string of removable cells $\alpha 1$ which communicate to an area 16 bounded by an inhibited area 14, a long string of removable cells $\alpha 2$ which communicate to an empty space, and a string of removable cells $\gamma$ which share a common boundary with the obstacle 13. On the other hand, the windows in the obstacle 13 are composed of a short string of removable cells $\beta 1$ communicating to the closed area 16 and two strings of removable cells $\beta 2$ communicating to an empty space and spaced apart by a string of unremovable cells $b$ which communicate to an area 17 bounded by an inhibited area 15. The number of removable cells in each window corresponds to the number of paths that can be passed through it. Therefore, two alternative routes are available between terminals 10 and 11, one going through the window formed by removable cells $\gamma$, as indicated by a dotted line 18 and the other through the windows formed by removable cells $\alpha 1$ and $\beta 1$, as indicated by a dotted line 19.

In block 26, controller 4 goes on to determine several obstructing paths each having a window size whose value is at least "1" from a given source pin terminal and a window size whose value is also at least 1 from a destination pin terminal. Following this determination, controller 4 assigns different levels of priority of such obstructing paths.

First-order priority is assigned exclusively to an obstructing path which involves the removal of a smaller number of cells. If window sizes of different values exist for a set of obstructing paths, second-order priority is given to one whose smaller window size is the largest of the smaller window sizes of such obstructing paths. For example, if a first obstructing path has a window size "5" for its source pin terminal and a window size "1" for its destination pin terminal and if a second obstructing path has a window size "4" for its source pin terminal and a window size "2" for its destination pin terminal, second-order priority is then given to the second obstructing path since its smaller window size "2" is the largest of the smaller window sizes of the two obstructing paths.

If window sizes of equal values exist for each of a set of obstructing paths, third-order priority is given to one whose total value of window sizes for both source and sink terminals is larger than the total of any other obstructing paths. For example, if a first obstructing path has window sizes "5" and "5" and a second obstructing path has window sizes "4" and "4", the first obstructing path is assigned third-order priority. Therefore, in the example of Fig. 3, route 18 is assigned priority. The prioritized obstructing paths are stored into the rerouting memory 2 according to their priorities so that the obstructing path of highest priority is recalled first from the rerouting memory 2 during a subsequent read mode.

To rip up an obstructing path on the cell map, exit then is to operations block 27 which reads data from the rerouting memory 2 identifying that obstructing path and erases path information of the obstructing path from the output memory 3. Data concerning the removed path is then stored into the input memory 1 to update the topology of the cell map accordingly.

Control exits to block 28 to find a new path through the removed obstructing path, using the most recent topology data stored in memory 1. If the attempted path is intercepted by obstructing paths (block 29), control advances to block 30 to replace the removed path and goes to block 31 to restore data concerning the replaced path by updating the input and output memories 1 and 3. Control then returns to block 27 to read an obstructing path having lower priority than the previous obstructing path. In this way, the reading process is repeated and obstructing paths of successively lower priorities are removed for retrial.

If negative decision is made in block 29, exit is to block 32 in which the a connection is established through the removed path and input memory 1 is updated according to the established connection, and data concerning the newly drawn path is stored into the output memory 3. Control then exits to block 33 to find a substitute path for the removed blocking path using the most recent data updated by block 33.

Control now returns to block 23 to determine if the attempt to find the substitute path is intercepted by obstructing paths and, if not, proceeds to block 24 to establish a connection along the unobstructed path and update memories 1 and 3 in a manner as described. If the answer is affirmative in block 23, control proceeds to block 26 to determine window sizes and priorities with respect to obstructing paths which are in the way of the attempted substitute path and to assign priorities to such obstructing paths in a manner similiar to that described above. Blocks 23 through 33 are repeated to find and draw the substitute path for the removed path.

When all paths are drawn successfully, affirmative decision will be made in block 25 and control advances to the end of the program.

The foregoing description shows only one preferred embodiment of the present invention. Various modifications are apparent to those skilled in the art without departing from the scope of the present invention which is only limited by the appended claims. For example, instead of advancing to operations block 34, control may proceed to operations block 22 as indicated by a dotted line 35 to find and draw a substitute path using the most recent data obtained by block 33. Therefore, the embodiment shown and described is only illustrative, not restrictive.

## Claims

1. A method for establishing electrical connections between pin terminals of each of a plurality of pairs, comprising the steps of:

(a) successively searching for a path for each of said pin terminal pairs and establishing a point-to-point connection if the searched path is not intercepted by obstructing paths;

(b) generating a plurality of routability indices if said searched path is intercepted by the obstructing paths, each of the routability indices representing a measure of the likelihood of finding a new path from each of said pin terminals through the obstructing paths, generating priorities of different levels according to the routability indices, and assigning said priorities to said obstructing paths;

(c) selecting one of said obstructing paths according to said priorities;

(d) removing the selected path and searching for a new path through the removed obstructing paths to determine if it is intercepted by further obstructing paths;

(e) if the new path is not intercepted by further obstructing paths, establishing a connection, and repeating the steps (a) to (d) for the removed obstructing path; and

(f) if the new path is intercepted by further obstructing paths, replacing the obstructing path which is removed by the step (d), and repeating the steps (c) to (e).

2. A method as claimed in claim 1, wherein the routability index is represented by the number of paths that can be passed through a removed segment of an obstructing path.

3. A method for establishing electrical connections between pin terminals of each of a plurality of pairs, comprising the steps of:

(a) successively searching for a path for each of said pin terminal pairs and establishing a point-to-point connection if the searched path is not intercepted by obstructing paths;

(b) generating a plurality of routability indices if said searched path is intercepted by the obstructing paths, each of the routability indices representing a measure of the likelihood of finding a new path from each of said pin terminals through said obstructing paths, generating priorities of different levels according to the routability indices, and assigning said priorities to said obstructing paths;

(c) selecting one of said obstructing paths according to said priorities;

(d) removing the selected path and searching for a new path through the removed obstructing path to determine if the new path is intercepted by further obstructing paths;

(e) if the new path is not intercepted by further obstructing paths, establishing a connection, searching for a substitute of the removed obstructing path, establishing a connection for the removed path if the substitute is not intercepted by further obstructing paths, and repeating the steps (b) to (f) for the substitute if same is intercepted by further obstructing paths; and

(f) if the new path is intercepted by further obstructing paths, replacing the obstructing path which is removed by the step (d), and repeating the steps (c) to (e).

4. A method as claimed in claim 3, wherein the routability index is represented by the number of paths that can be passed through a removed segment of an obstructing path.

# Fig. 1

# Fig. 3

# Fig. 2

START

Read data from memory 1 — 21

Find path — 22

35

Obstacles ? — 23
— No →
— Yes ↓

Update memory 1 and store new path data into memory 3 — 24

All paths drawn ? — 25
— No →
— Yes ↓

STOP

Determine window sizes, derive priorities from window sizes, assign priorities to obstructing paths and store prioritized paths into rerouting memory 2 according to their priorities — 26

Read obstructing path from memory 2, erase it from memory 3, and update memory 1 — 27

Find new path through removed path — 28

Obstacles ? — 29
— Yes →
— No ↓

Replace removed path — 30

Update memories 1 & 3 — 31

Update memory 1 and store new path data into memory 3 — 32

Find and draw subsitute for removed path — 33